(19) Europäisches Patentamt
European Patent Office
Office européen des brevets

(11) **EP 1 770 728 A2**

## (12) EUROPEAN PATENT APPLICATION

(43) Date of publication:
**04.04.2007 Bulletin 2007/14**

(51) Int Cl.:
***H01G 9/20*** (2006.01)

(21) Application number: **06253595.0**

(22) Date of filing: **10.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **29.09.2005 KR 20050091284**

(71) Applicant: **Samsung Electronics Co., Ltd.**
**Seoul 442-742 (KR)**

(72) Inventors:
• **Nam, Jung Gyu**
**Yongin-si**
**Gyeonggi-do 449-737 (KR)**

• **Park, San Cheol**
**Songpa-gu 138-769 (KR)**
• **Park, Young Jun**
**Yeongtonggu**
**Suwon-si**
**Gyeonggi-do 443-370 (KR)**

(74) Representative: **Greene, Simon Kenneth**
**Elkington and Fife LLP,**
**Prospect House,**
**8 Pembroke Road**
**Sevenoaks,**
**Kent TN13 1XR (GB)**

(54) **Tandem photovoltaic device and fabrication method thereof**

(57)     Disclosed herein is a tandem photovoltaic device comprising two or more photovoltaic layers laminated to each other, each of which including a semiconductor electrode, an electrolyte layer and a counter electrode. A counter electrode of the upper photovoltaic layer is patterned in a grid shape so as to include a plurality of light-transmitting portions, which permit transmission of light to the lower photovoltaic layer. The tandem photovoltaic device has the advantages of high power conversion efficiency and degree of integration. Advantageously, the tandem photovoltaic device can reduce electric power generation costs.

Further disclosed is a method for fabricating the tandem photovoltaic device.

**FIG. 3**

**Description**

BACKGROUND OF THE INVENTION

The present invention relates to a tandem photovoltaic device and a method for fabricating the photovoltaic device. More particularly, the present invention relates to a tandem photovoltaic device with high degree of integration and improved power conversion efficiency in which a first counter electrode is patterned so as to include a plurality of light-transmitting portions, and a method for fabricating the photovoltaic device.

Since solar cells, which are kinds of photovoltaic devices for converting solar energy into electric energy, utilize inexhaustible solar energy, unlike other energy sources, and are environmentally friendly, they are gradually gaining importance. Particularly, when solar cells are used as power sources in portable digital communication devices, such as portable computers, cell phones and personal digital assistants (PDAs), they are expected to be charged by solar power only.

Monocrystalline or polycrystalline silicon solar cells have been mainly used. However, silicon solar cells require the use of huge, expensive equipment and costly raw materials, incurring considerable fabrication costs. In addition, silicon solar cells present numerous difficulties in improving the conversion efficiency of solar energy into electric energy.

Under such circumstances, there has been an increasing interest in solar cells using organic materials that can be fabricated at reduced costs. Particularly, dye-sensitized solar cells have received a great deal of attention due to their low fabrication costs.

Dye-sensitized solar cells are photoelectrochemical solar cells that comprise a porous semiconductor film consisting of a transparent electrode and nanoparticles adhered to the transparent electrode, a dye adsorbed on the surface of the semiconductor film, and a redox electrolytic solution filled into a space between two electrodes. Since metal oxide semiconductor films used in dye-sensitized solar cells have an extremely large surface area, large quantities of dyes can be fixed to the surface of the semiconductor films and thus the light absorption efficiency of the cells is advantageously increased.

With recent advances in technologies associated with dye-sensitized solar cells, a number of studies have been undertaken to further improve the power conversion efficiency of solar cells.

To produce high voltages from conventional dye-sensitized solar cells, unit cells are connected in tandem, which requires a large area. Accordingly, dye-sensitized solar cells are not suitable for use in a variety of portable electronic devices that are becoming gradually smaller in size and thickness.

Various attempts have been made to develop multilayer solar cells with higher efficiency. In dye-sensitized solar cells, electric energy is generated when light is incident on a dye but the light absorbed by the dye is lost. For these reasons, it has been believed that solar cells cannot be successfully fabricated into multilayer structures.

Some trials have been introduced to overcome the above-mentioned technical limitations. For example, U.S. Patent No. 6,340,789 discloses a multilayer photovoltaic device comprising a first semiconductive layer and a second semiconductive layer which are laminated together so as to form a mixed layer between the two semiconductive layers wherein at least some of the first and second semiconductive layers are retained on either side of the mixed layer.

On the other hand, European Patent Laid-open No. 1 513 171 A1 discloses a tandem photovoltaic device comprising at least two compartments, each compartment comprising a transparent substrate, a transparent conducting oxide, a semiconducting blocking layer, a porous layer, a charge-transporting agent and a counter electrode wherein the counter electrode is a semitransparent back electrode having a transmittance of 30% or more.

SUMMARY OF THE INVENTION

In accordance with one aspect of the present invention there is provided a tandem photovoltaic device comprising,
a first photovoltaic layer including a first transparent electrode having a substrate and a conductive material coated on the substrate, a first light-absorbing layer formed on the first transparent electrode and whose surface is adsorbed by a dye, a first counter electrode arranged opposite to the first transparent electrode, and an electrolyte layer filled into a space between the first transparent electrode and the first counter electrode, and
a second photovoltaic layer including a second transparent electrode having a substrate and a conductive material coated on the substrate, a second light-absorbing layer formed on the second transparent electrode and whose surface is adsorbed by a dye, a second counter electrode arranged opposite to the second transparent electrode, and an electrolyte layer filled into a space between the second transparent electrode and the second counter electrode, wherein the first counter electrode has a grid pattern.

The counter electrode having a grid pattern may be a transparent electrode on which a conductive material is patterned in a line or lattice form. The pattern type of the first counter electrode is not particularly restricted, and any pattern may be employed in the first counter electrode so long as it permits transmission of light to the lower photovoltaic layer.

The first light-absorbing layer may be a monolayer composed of fine particles. The second light-absorbing layer may be a double layer consisting of a fine particle layer and a coarse particle layer or may be a mixed monolayer composed of a mixture of fine particles and coarse particles.

In accordance with another aspect of the present invention, there is provided a method for fabricating a tandem photovoltaic device, comprising the steps of:

(a) forming a first light-absorbing layer on a first transparent electrode;

(b) arranging a first counter electrode having a grid pattern so as to be opposite to the first transparent electrode;

(c) filling an electrolyte into a space formed between the first transparent electrolyte and the first counter electrode to form a first photovoltaic layer;

(d) forming a second light-absorbing layer on a second transparent electrode, arranging a second counter electrode so as to be opposite to the second transparent electrode, and filling an electrolyte into a space formed between the second transparent electrode and the second counter electrode to form a second photovoltaic layer; and

(e) adhering the first photovoltaic layer to the second photovoltaic layer.

The present invention has been made in view of the problems discussed above. One aim of the present invention to provide a tandem photovoltaic device that can generate a high voltage per unit area.

Another aim of the present invention is to provide a tandem photovoltaic device by which the electric power generation costs of the photovoltaic device can be reduced and the power conversion efficiency of the photovoltaic device can be improved.

BRIEF DESCRIPTION OF THE DRAWINGS

The above and other objects, features and other advantages of the present invention will be more clearly understood from the following detailed description taken in conjunction with the accompanying drawings, in which:

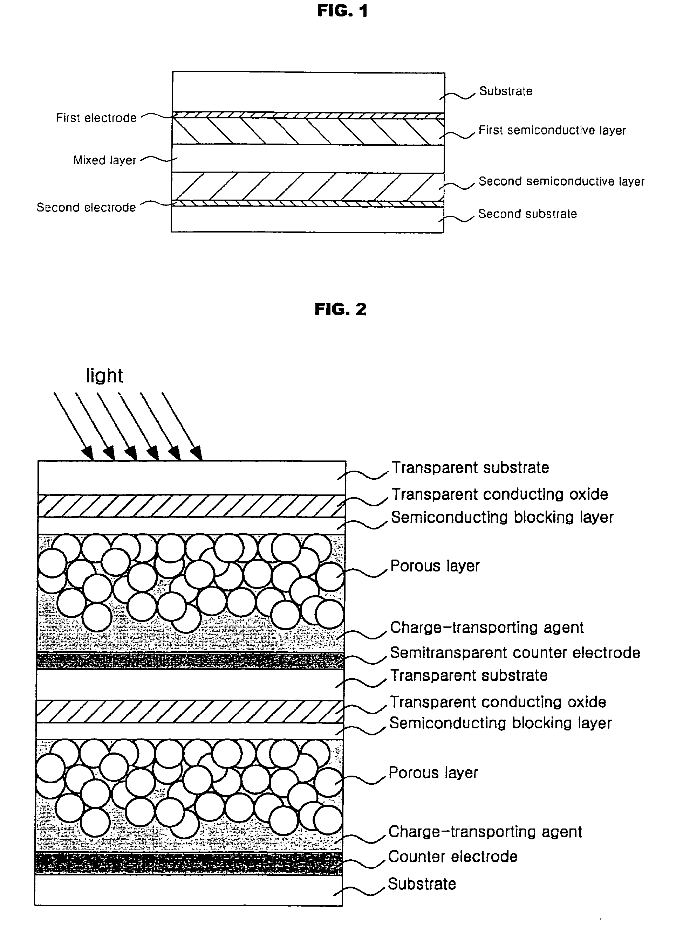

Fig. 1 is a cross-sectional view schematically showing the structure of a conventional tandem photovoltaic device;

Fig. 2 is a cross-sectional view schematically showing the structure of another conventional tandem photovoltaic device;

Fig. 3 is a cross-sectional view schematically showing the structure of a tandem photovoltaic device according to one embodiment of the present invention;

Figs. 4a to 4c are plan views schematically showing various shapes of a first counter electrode of a tandem photovoltaic device according to the present invention;

Fig. 5 is a cross-sectional view schematically showing the structure of a tandem photovoltaic device according to another embodiment of the present invention;

Fig. 6 is a cross-sectional view schematically showing the structure of a tandem photovoltaic device according to another embodiment of the present invention; and

Fig. 7 is a process view schematically showing a method for fabricating a tandem photovoltaic device according to an embodiment of the present invention;

DESCRIPTION OF THE PREFERRED EMBODIMENTS

The present invention will now be described in more detail with reference to the accompanying drawings.

The tandem photovoltaic device of the present invention is designed to produce a high electric power per unit area. The tandem photovoltaic device of the present invention has a multilayer structure wherein two or more photovoltaic layers are laminated, each of the photovoltaic layers including a semiconductor electrode having a transparent electrode and a light-absorbing layer, an electrolyte and a counter electrode. Generally, the light-absorbing layer is composed of a metal oxide semiconductor whose surface is adsorbed by a photosensitive dye.

In the tandem photovoltaic device of the present invention, the counter electrodes included in the respective photovoltaic layers have different structures. Specifically, the counter electrode of the uppermost photovoltaic layer, where sunlight is directly absorbed, includes a patterned metal electrode so that it includes a plurality of light-transmitting portions, thus transmitting the incident light to the lower photovoltaic layer. In addition, the first counter electrode has a large specific surface area so as to allow reduction and oxidation reactions to well proceed. On the other hand, the second counter electrode of the lower photovoltaic layer is produced by uniformly coating a metal electrode, e.g., a platinum electrode, over the entire surface of a conductive material.

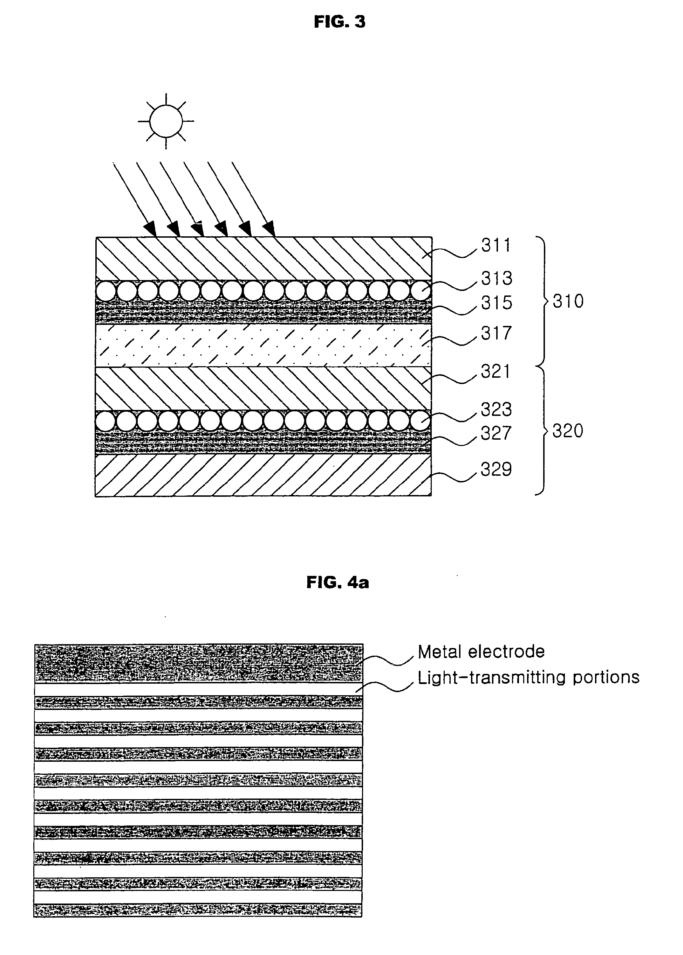

Fig. 3 is a cross-sectional view schematically showing the structure of a photovoltaic device according to one embodiment of the present invention. Referring to Fig. 3, the photovoltaic device according to this embodiment of the present invention comprises: a first photovoltaic layer 310 including a first transparent electrode 311 having a substrate and a conductive material coated on the substrate, a first light-absorbing layer 313 formed on the first transparent electrode and whose surface is adsorbed by a dye, a first counter electrode 317 arranged opposite to the first transparent electrode, and an electrolyte layer 315 filled into a space between the first transparent electrode and the first counter electrode; and a second photovoltaic layer 320 including a second transparent electrode 321 consisting of a substrate and a conductive material coated on the substrate, a second light-absorbing layer 323 formed on the second transparent electrode and whose surface is adsorbed by a dye, a second counter electrode 329 arranged opposite to the second transparent electrode, and an electrolyte layer 327 filled into a space between the second transparent electrode and the second counter electrode.

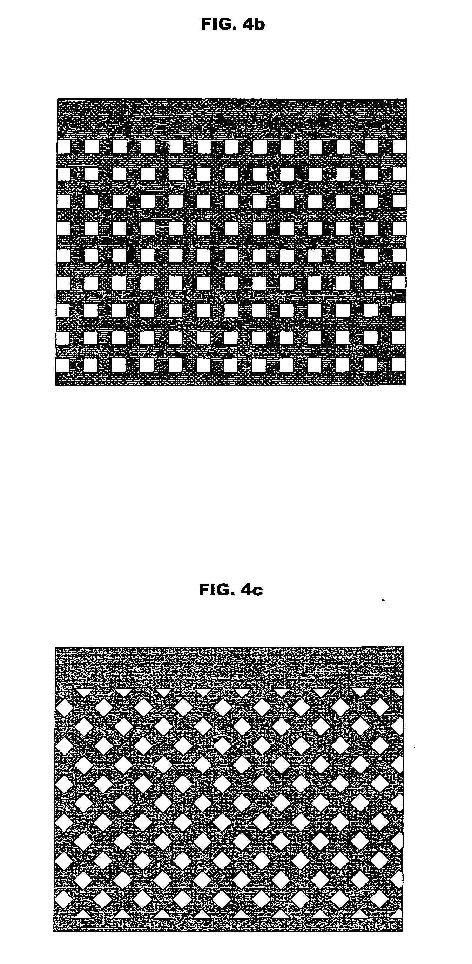

The first counter electrode 317 has a grid pattern so as to include a plurality of light-transmitting portions through which the incident light can be transmitted to the second photovoltaic layer 320. Figs. 4a to 4c show various shapes of the grid electrode. The grid electrode may have a line form as shown in Fig. 4a, or a lattice form as shown in Fig. 4b or 4c.

The second counter electrode 329 of the photovoltaic device according to the present invention is produced by uniformly coating a metal electrode over the entire surface of a conductive material. The second counter electrode 329 can be made of, without limitation, an electrically conductive material. So long as a conductive layer is disposed on the surface of the second counter electrode facing the second transparent electrode, the second counter electrode may be made of any insulating material. It is preferred to use an electrochemically stable material to constitute the second counter electrode. Specific examples of preferred electrochemically stable materials include platinum, gold, carbon, and carbon nanotubes (CNTs). For the purpose of improving the catalytic effects of oxidation and reduction, it is preferred that the surface of the second counter electrode facing the second transparent electrode have a microstructure with increased surface area. For example, the second counter electrode is preferably made of platinum black or porous carbon.

To achieve high efficiency of the photovoltaic device according to the present invention, it is necessary for the first and second light-absorbing layers 313 and 323 to absorb as much solar energy as possible. To this end, the first and second light-absorbing layers are composed of a porous metal oxide semiconductor having a large surface area, and a dye is absorbed within the pores. The light-absorbing layers can be composed of, for example, at least one metal oxide selected from the group consisting of oxides of titanium, niobium, hafnium, indium, tin, and zinc, but the present invention is not limited to these metal oxides. These metal oxides may be used alone or in any combination. Preferred is titanium oxide ($TiO_2$).

It is preferred that the metal oxides constituting the first and second light-absorbing layers 313 and 323 have a large surface area so that a dye adsorbed on the surface of the metal oxides absorbs as much light as possible and the degree of adsorption to the electrolyte layers 315 and 327 is increased. Accordingly, the metal oxides constituting the light-absorbing layers have a nanostructure, such as nanotubes, nanowires, nanobelts or nanoparticles.

The first and second transparent electrodes 311 and 321 of the photovoltaic device according to the present invention are formed by coating a conductive material on a substrate. The substrate may be of any type so long as it is transparent, and examples thereof include transparent inorganic substrates, such as quartz and glass, and transparent plastic substrates, such as polyethylene terephthalate (PET), polyethylene naphthalate (PEN), polycarbonate, polystyrene and polypropylene. As the conductive material coated on the substrate, there can be used indium tin oxide (ITO), fluorine-doped tin oxide (FTO), $ZnO-Ga_2O_3$, $ZnO-Al_2O_3$ or $SnO_2-Sb_2O_3$.

The first and second light-absorbing layers 313 and 323 of the photovoltaic device according to the present invention are formed by adsorbing a dye on the surface of the metal oxide layers. The dye absorbs light and undergoes electronic transitions from the ground state to the excited state to form electron-hole pairs. The excited electrons are injected into a conduction band of the metal oxide light-absorbing layers and transferred to the electrodes to generate an electromotive force.

The kinds of the dye are not particularly restricted so long as the dye is generally used in the field of solar cells. Ruthenium complexes are preferred. In addition to ruthenium complexes, any dye may be used, without particular limitation, if it has charge separation functions and exhibits sensitizing functions. As suitable dyes, there can be mentioned, for example: xanthene-type colorants, such as Rhodamine B, Rose Bengal, eosin and erythrosine; cyanine-type colorants, such as quinocyanine and cryptocyanine; basic dyes, phenosafranine, Capri blue, thiosine, and Methylene Blue; porphyrin-type compounds, such as chlorophyll, zinc porphyrin, and magnesium porphyrin; azo colorants; phthalocyanine compounds; complex compounds, such as Ru trisbipyridyl; anthraquinone-type colorants; polycyclic quinone-type colorants; and the like. These dyes may be used alone or in combination of two or more of the dyes.

The electrolyte layer of the photovoltaic device according to the present invention is composed of an electrolytic solution, for example, a solution of iodine in acetonitrile, an N-methyl-2-pyrrolidone (NMP) solution, or a 3-methoxypropionitrile solution. Any electrolytic solution may be used, without limitation, so long as it exhibits hole conductivity.

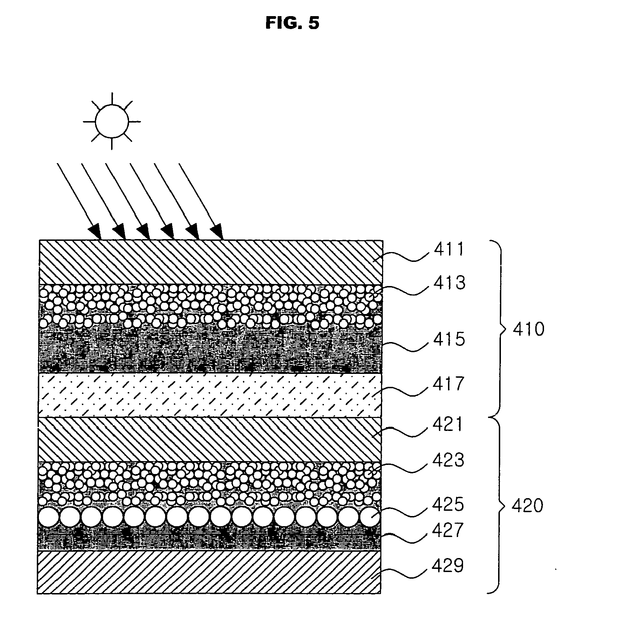

In another embodiment of the present invention, the first light-absorbing layer of the first photovoltaic layer and the second light-absorbing layer of the second photovoltaic layer can be composed of metal oxides having different particle sizes. A tandem photovoltaic device according to this embodiment of the present invention is shown Fig. 5.

Referring to Fig. 5, a first light-absorbing layer 413 of a first photovoltaic layer 410 may be a monolayer composed of fine partides, and a second light-absorbing layer of a second photovoltaic layer 420 may be a double layer consisting of a fine particle layer 423 and a coarse particle layer 425, which are formed using two different kinds of metal oxides. The coarse particle layer 425 scatters light passed through the fine particle layer 423 to return the scattered light to the fine particle layer 423, thereby serving to improve the light absorptivity. For example, the fine particle layer 423 of the second light-absorbing layer is composed of a metal oxide having a particle size of 5-50 nm, and the coarse particle layer 425 can be composed of a metal oxide having a particle size of 100-400 nm.

Alternatively, the second light-absorbing layer 423 may be a mixed monolayer composed of a mixture of fine particles and coarse particles. At this time, the coarse particles scatter the incident light to improve the sunlight utilization efficiency of the photovoltaic device.

The constitutions of the transparent electrodes 411 and 421, the electrolyte layers 415 and 427, and the first and second counter electrodes 417 and 429 are the same as those described in the previous embodiment.

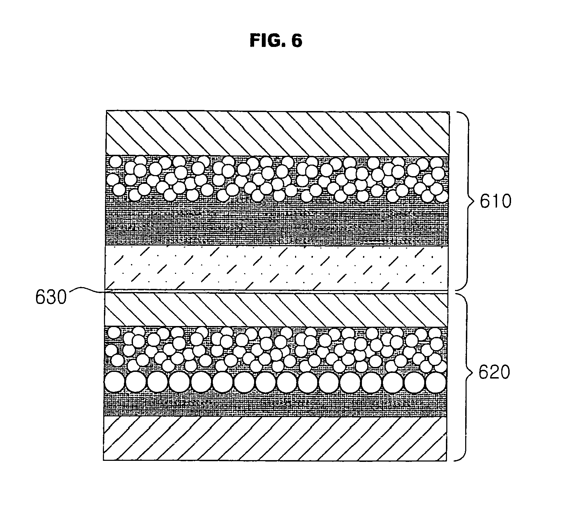

In another embodiment of the present invention, the tandem photovoltaic device may further comprise a light-scattering layer positioned between the first and second photovoltaic layers. The tandem photovoltaic device according to this embodiment of the present invention is shown in Fig. 6. As shown in Fig. 6, a light-scattering layer 630 is formed between first photovoltaic layers 610 and 620. Light passed through a first counter electrode of the first photovoltaic layer may not evenly reach the second photovoltaic layer due to rectilinear propagation property of light. The light-scattering layer 630 acts to uniformly distribute the light passed through the first photovoltaic layer to the second photovoltaic layer. Suitable materials for the light-scattering layer include, but are not limited to, powders of metal oxides, such as $TiO_2$, $In_2O_3$, $SnO_2$, $VO$, $VO_2$, $V_2O_3$, and $V_2O_5$. The metal oxide powder is coated by a wet coating technique, followed by annealing at a particular temperature of less than 500°C to form the light-scattering layer.

In another aspect, the present invention is directed to a method for fabricating a tandem photovoltaic device. The method of the present invention comprises the steps of: forming a first photovoltaic layer including a first semiconductor electrode consisting of a first transparent electrode and a first light-absorbing layer, an electrolyte layer, and a first counter electrode; and forming a second photovoltaic layer including a second semiconductor electrode consisting of a second transparent electrode and a second light-absorbing layer, an electrolyte layer, and a second counter electrode wherein the method comprises the step of patterning the first counter electrode of the first photovoltaic layer so that the first counter electrode includes a plurality of light-transmitting portions.

According to the method of the present invention, an electrolyte is injected into a space formed between the first transparent electrode and the first counter electrode, and a space formed between the second transparent electrode and the second counter electrode, completing the formation of the first and second photovoltaic layers. Thereafter, the first and second photovoltaic layers are adhered to each other to complete the final multilayer structure. As an alternative, the multilayer structure can be formed by forming first and second photovoltaic layers containing no electrolytic solution, adhering the photovoltaic layers to each other, followed by injection of an electrolytic solution. Specifically, the multilayer structure can be formed in accordance with the following procedure. First, a first light-absorbing layer and a first counter electrode are sequentially formed on a first transparent electrode to form a first photovoltaic layer. Separately, a second light-absorbing layer and a second counter electrode are sequentially formed on a second transparent electrode to form a second photovoltaic layer. Subsequently, the photovoltaic layers are adhered and sealed to each other. An electrolytic solution is injected into spaces formed within the photovoltaic layers through an electrolyte inlet and then the electrolyte inlet is sealed to form the final multilayer structure.

The transparent electrodes, the light-absorbing layers, the electrolyte layers constituting the respective photovoltaic layers can be composed of the same or different materials. For example, a dye adsorbed on the surface of a metal oxide layer of the first light-absorbing layer may be identical to or different from that adsorbed on the surface of a metal oxide layer of the second light-absorbing layer.

Specifically, a method for fabricating a photovoltaic device according to one embodiment of the present invention comprises the following steps:

(a) forming a first light-absorbing layer on a first transparent electrode;
(b) arranging a first counter electrode having a grid pattern so as to be opposite to the first transparent electrode;
(c) filling an electrolyte into a space formed between the first transparent electrolyte and the first counter electrode to form a first photovoltaic layer;
(d) forming a second light-absorbing layer on a second transparent electrode, arranging a second counter electrode so as to be opposite to the second transparent electrode, and filling an electrolyte into a space formed between the second transparent electrode and the second counter electrode to form a second photovoltaic layer; and
(e) adhering the first photovoltaic layer to the second photovoltaic layer.

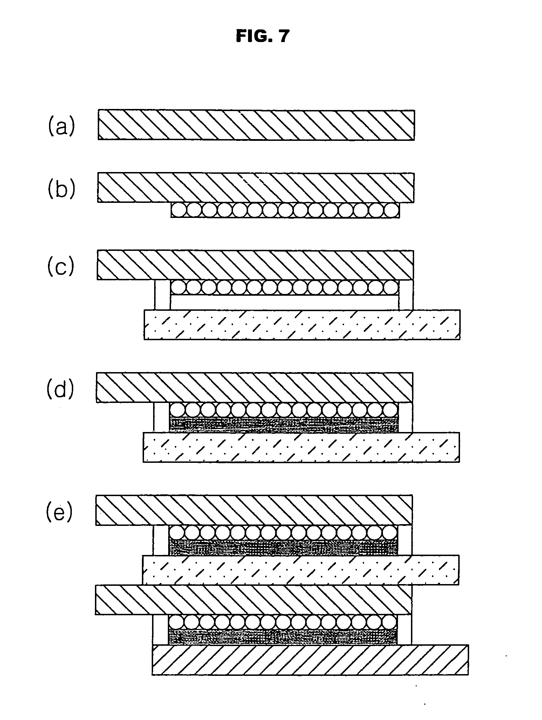

Fig. 7 schematically shows the procedure of the method for fabricating a tandem photovoltaic device according to the present invention.

The method for fabricating a photovoltaic device according to the present invention will be explained in more detail based on the respective steps.

Step (a)

First, a transparent electrode coated with a conductive material is prepared. A first light-absorbing layer made of a metal oxide is formed on one surface of the transparent electrode. The formation of the first light-absorbing layer can be achieved by general coating techniques, for example, spraying, spin coating, dipping, printing, doctor blading and sputtering, and electrophoresis.

As is well known in the art, the formation of the first light-absorbing layer by the general coating technique involves drying and baking after coating. The drying can be performed at about 50°C to about 100°C, and baking can be performed at about 400°C to about 500°C.

Next, the first light-absorbing layer is impregnated with a solution containing a photosensitive dye for 12 hours, in accordance with a general procedure widely used in the art, to adsorb the dye on the metal oxide. Examples of suitable solvents that can be used in the solution containing a photosensitive dye include *tert*-butyl alcohol, acetonitrile, and a mixture thereof.

Step (b)

The first counter electrode of the first photovoltaic layer is formed by coating a transparent electrode with a metal electrode in the form of a grid, lattice, mesh, or the like. Specifically, a conductive material, *e.g.,* fluorine-doped tin oxide (FTO), is coated on a transparent substrate, and is patterned using a mask to form a patterned electrode. Examples of such patterning methods include, but are not particularly limited to, e-beam coating, sputtering, vacuum evaporation, ion plating, and chemical vapor deposition (CVD).

Step (c)

The first transparent electrode is arranged opposite to the first counter electrode and then a space between the electrodes is formed using a particular sealing member in accordance with a technique commonly known in the art. An electrolytic solution is injected into the space to form a first photovoltaic layer. At this time, the electrolytic solution can be sealed by various techniques. For example, the two electrodes are adhered in a plane-to-plane manner using an adhesive. After a fine hole penetrating the first transparent electrode and the first counter electrode is formed, an electrolytic solution is injected into the space formed between the electrodes through the hole. Thereafter, the hole are sealed using the adhesive.

Step (d)

A second photovoltaic layer is formed by the same procedure as in the formation of the first photovoltaic layer. Thereafter, the first photovoltaic layer is adhered to the second photovoltaic layer to fabricate a tandem photovoltaic device. At this time, a second counter electrode is formed by coating the entire surface with a metal electrode. To improve the light absorptivity, a second light-absorbing layer of the second photovoltaic layer can be formed into a double layer by using two kinds of metal oxides having different particle sizes.

The second photovoltaic layer may have a double layer consisting of a fine particle layer having a thickness of 10-20 $\mu$m and a coarse particle layer having a thickness of 3-5 $\mu$m. At this time, the fine particle layer is composed of a metal oxide having a particle size of 9-20 nm and the coarse particle layer is composed of a metal oxide having a particle size of 200-400 nm. Alternatively, the second photovoltaic layer may be a mixed monolayer composed of a mixture of the fine particles and the coarse particles.

Step (e)

In this step, the first photovoltaic layer can be adhered to the second photovoltaic layer using an adhesive by any techniques widely known in the art to which the present invention pertains. The adhesive used herein is a thermoplastic polymer film (e.g., SURLYN, DuPont), an epoxy resin, or ultraviolet (UV) hardener. The adhesive, such as a thermoplastic polymer film, is interposed between the first and second photovoltaic layers, followed by thermal pressing to adhere the photovoltaic layers to each other.

If necessary, the method of the present invention may further comprise the step of forming a light-scattering layer between the first and second photovoltaic layers.

Hereinafter, the present invention will be explained in more detail with reference to the following examples, including preparative examples. However, these examples are given for the purpose of illustration and are not to be construed as limiting the scope of the invention.

**Example 1**

After fluorine-doped tin oxide (FTO) was applied to a glass substrate using a sputter, a paste of $TiO_2$ particles (average particle diameter: 9 nm) was applied thereto by screen printing and dried at 70°C for 30 minutes. After drying, the resulting structure was placed in an electric fumace, heated at a rate of 3°C/min. in air, maintained at 450°C for 30 minutes, and cooled at a rate of 3 °C/min. to produce a porous $TiO_2$ film having a thickness of about 10 $\mu$m. Subsequently, the glass substrate on which the metal oxide layer was formed was dipped in a 0.3 mM ruthenium dithiocyanate 2,2'-bipyridyl-4,4'-dicarboxylate solution for 24 hours and dried to adsorb the dye on the surface of the $TiO_2$ layer. After completion of the adsorption of the dye, ethanol was sprayed to remove the unadsorbed dye and dried, completing formation of a first light-absorbing layer of a first photovoltaic layer. Next, platinum was patterned in a grid shape on an indium tin oxide (ITO)-coated glass substrate to form a patterned platinum film thereon, and thereafter a fine hole for injection of an electrolyte was formed using a drill (diameter: 0.75 mm) thereon to produce a first counter electrode.

A second photovoltaic layer was formed by the same procedure as in the formation of the first photovoltaic layer.

Subsequently, a polymer (SURLYN, DuPont) having a thickness of about 40 $\mu$m was interposed between the first and second photovoltaic layers, and the two photovoltaic layers were adhered to each other under a pressure of about 2 atm on a hot plate at about 120°C. An electrolytic solution was filled into a space formed between the two photovoltaic layers through the fine hole to fabricate a tandem photovoltaic device. At this time, as the electrolytic solution, an $I_3^-/I^-$ electrolytic solution of 0.6 moles of 1,2-dimethyl-3-octyl-imidazolium iodide, 0.2 moles of Lil, 0.04 moles of $I_2$ and 0.2 moles of 4-*tert*-butyl-pyridine (TBP) in acetonitrile was used.

**Example 2**

A tandem photovoltaic device was fabricated in the same manner as in Example 1, except that the second light-absorbing layer of the second photovoltaic layer was a double layer formed by laminating a paste of $TiO_2$ particles having a particle diameter of 9 nm to a thickness of 10 $\mu$m and a paste of $TiO_2$ particles having a particle diameter of 200 nm to a thickness of 5 $\mu$m.

**Example 3**

A tandem photovoltaic device was fabricated in the same manner as in Example 2, except that a light-scattering layer was formed on the second transparent electrode of the second photovoltaic layer. At this time, the light-scattering layer was formed by spin coating a metal oxide ($TiO_2$) slurry on the second transparent electrode, followed by annealing.

**Comparative Example 1**

After fluorine-doped tin oxide (FTO) was applied to a glass substrate using a sputter, a paste of $TiO_2$ particles (average partide diameter: 9 nm) was applied thereto by screen printing and baked at 450°C for 30 minutes to a porous $TiO_2$ film having a thickness of about 10 $\mu$m. Subsequently, the resulting structure was dipped in a 0.3 mM ruthenium dithiocyanate 2,2'-bipyridyl-4,4'-dicarboxylate solution for 24 hours and dried to adsorb the dye on the surface of the $TiO_2$ layer, completing the production of a semiconductor electrode. Separately, a platinum film was formed on an indium tin oxide (ITO)-coated glass substrate using a sputter, and a fine hole for injection of an electrolyte was formed thereon using a drill having a diameter of 0.75 mm to produce a counter electrode. Subsequently, a polymer (SURLYN, DuPont) having a thickness of about 40 $\mu$m was interposed between the counter electrode and the semiconductor electrode, and the two electrodes were adhered to each other under a pressure of about 2 atm on a hot plate at about 120°C. An electrolytic solution was filled into a space formed between the two electrodes through the fine hole to fabricate a monolayer photovoltaic device. At this time, as the electrolytic solution, an $I_3^-/I^-$ electrolytic solution of 0.6 moles of 1,2-dimethyl-3-octyl-imidazolium iodide, 0.2 moles of Lil, 0.04 moles of $I_2$ and 0.2 moles of 4-*tert*-butyl-pyridine (TBP) in acetonitrile was used.

**[Evaluation of characteristics of photovoltaic devices]**

To evaluate the power conversion efficiency of the photovoltaic devices fabricated in Examples 1 to 2 and Comparative Example 1, the photovoltages and photocurrents of the devices were measured. For the measurements, a xenon lamp (01193, Oriel) was used as a light source, and a standard solar cell (Frunhofer Institute Solar Engeriessysteme, Certificate No. C-ISE369, Type of material: Mono-Si$^+$ KG filter) was used to compensate for the simulated illumination conditions (AM 1.5) of the xenon lamp. The current density ($I_{sc}$), voltage ($V_{oc}$) and fill factor (FF) of the devices were calculated from the obtained photocurrent-photovoltage curves, and the power conversion efficiency ($\eta_e$) of the devices was calculated according to the following equation:

$$\eta_e = (V_{oc} \cdot I_{sc} \cdot FF)/(P_{inc})$$

where $P_{inc}$ is 100 mw/cm$^2$ (1 sun).

The obtained results are shown in Table 1.

**Table 1**

| Example No. | $I_{sc}$ (mA) | $V_{oc}$ (mV) | Fill factor (FF) | $P_m$ (W) | Power conversion efficiency (%) |
|---|---|---|---|---|---|
| Example 1 | 8.720 | 1330.00 | 0.529 | 6.140 | 6.079 |
| Example 2 | 9.925 | 1519.667 | 0.547 | 8.251 | 8.028 |
| Comparative Example 1 | 10.937 | 752.181 | 0.620 | 5.100 | 4.963 |

It is obvious from the results shown in Table 1 that the photovoltaic devices of the present invention produce a high electric power per unit area and exhibit a high power conversion efficiency. Particularly, the photovoltaic device having a double layer structure of a fine particle layer and a coarse particle layer as a second light-absorbing layer exhibits a higher power conversion efficiency.

Although the preferred embodiments of the present invention have been disclosed for illustrative purposes, those skilled in the art will appreciate that various modifications are possible, without departing from the scope and spirit of the invention as disclosed in the appended claims. Accordingly, such modifications are intended to come within the scope of the appended claims.

As apparent from the above description, the tandem photovoltaic device of the present invention can generate a high voltage per unit area. In addition, since the first counter electrode of the first photovoltaic layer is patterned to include a plurality of light-transmitting portions, the photovoltaic device of the present invention has the advantage of high power conversion efficiency. Accordingly, the photovoltaic device of the present invention can reduce electric power generation costs and can be highly integrated.

Furthermore, by controlling the particle size of the metal oxide of the second photovoltaic layer, the sunlight utilization efficiency of the tandem photovoltaic device according to the present invention can be further improved due to diffraction effects of light.

**Claims**

1. A tandem photovoltaic device comprising,
   a first photovoltaic layer including a first transparent electrode having a substrate and a conductive material coated on the substrate, a first light-absorbing layer formed on the first transparent electrode and whose surface is adsorbed by a dye, a first counter electrode arranged opposite to the first transparent electrode, and an electrolyte layer filled into a space between the first transparent electrode and the first counter electrode, and
   a second photovoltaic layer including a second transparent electrode having a substrate and a conductive material coated on the substrate, a second light-absorbing layer formed on the second transparent electrode and whose surface is adsorbed by a dye, a second counter electrode arranged opposite to the second transparent electrode, and an electrolyte layer filled into a space between the second transparent electrode and the second counter electrode,
   wherein the first counter electrode has a grid pattern.

2. The tandem photovoltaic device according to claim 1, wherein the grid pattern is a line or lattice form.

3. The tandem photovoltaic device according to claim 1 or 2, wherein the first light-absorbing layer is a monolayer composed of fine particles, and the second light-absorbing layer is a double layer consisting of a fine particle layer and a coarse particle layer.

4. The tandem photovoltaic device according to claim 1 or 2, wherein the first light-absorbing layer is a monolayer composed of fine particles, and the second light-absorbing layer is a mixed monolayer composed of a mixture of fine particles and coarse particles.

5. The tandem photovoltaic device according to claim 3 or 4, wherein the fine particles are metal oxide particles having a particle size of 5-50 nm, and the coarse particles are metal oxide particles having a particle size of 100-400 nm.

6. The tandem photovoltaic device according to any one of claims 1 to 5, further comprising a light-scattering layer positioned between the first and second photovoltaic layers.

7. The tandem photovoltaic device according to claim 6, wherein the light-scattering layer is composed of a material selected from the group consisting of powders of the metal oxides $TiO_2$, $In_2O_3$, $SnO_2$, $VO$, $VO_2$, $V_2O_3$, and $V_2O_5$.

8. A method for fabricating a tandem photovoltaic device, comprising the steps of:

(a) forming a first light-absorbing layer on a first transparent electrode;
(b) arranging a first counter electrode having a grid pattern so as to be opposite to the first transparent electrode;
(c) filling an electrolyte into a space formed between the first transparent electrolyte and the first counter electrode to form a first photovoltaic layer;
(d) forming a second light-absorbing layer on a second transparent electrode, arranging a second counter electrode so as to be opposite to the second transparent electrode, and filling an electrolyte into a space formed between the second transparent electrode and the second counter electrode to form a second photovoltaic layer; and
(e) adhering the first photovoltaic layer to the second photovoltaic layer.

## FIG. 1

First electrode
Mixed layer
Second electrode

Substrate
First semiconductive layer
Second semiconductive layer
Second substrate

## FIG. 2

light

Transparent substrate
Transparent conducting oxide
Semiconducting blocking layer

Porous layer

Charge-transporting agent
Semitransparent counter electrode
Transparent substrate
Transparent conducting oxide
Semiconducting blocking layer

Porous layer

Charge-transporting agent
Counter electrode
Substrate

**FIG. 3**

**FIG. 4a**

Metal electrode

Light-transmitting portions

**FIG. 4b**

**FIG. 4c**

**FIG. 5**

**FIG. 6**

**FIG. 7**

(a)

(b)

(c)

(d)

(e)

**EP 1 770 728 A2**

**REFERENCES CITED IN THE DESCRIPTION**

**Patent documents cited in the description**

- US 6340789 B
- EP 1513171 A1